# EUROPEAN PATENT APPLICATION

(11) **EP 2 995 996 A1**
(43) Date of publication of application: **16.03.2016**
(21) Application number: 14184440.7
(22) Date of filing: 11.09.2014
(51) Int. Cl.: G03F 7/20, G02B 27/48

(54) **Optical system and method for homogenizing an illuminated area**

(71) Applicant: Liteq B.V., 5674 CC Nuenen (NL)
(72) Inventor: Abdi Vishkaee, Farhad, 5674 CC Nuenen (NL); Wichers, Hermen Jan, 5674 CC Nuenen (NL)
(74) Representative: V.O.

(57) **Abstract**

The present disclosure concerns an optical system and method. An optical diffuser (10) is configured to diffuse the light beam (L1) for homogenizing an intensity profile of the illuminated area (A1). The optical diffuser (10) comprises an optical element (2) disposed in a light path between the light source (1). The optical element (2) is configured to redirect the light beam (L1) towards an object plane (S1). An actuator (3) is configured to actuate the optical element (2) for varying a position (X1,Y1) of the illuminated area (A1) at the object plane (S1). A controller (4) is configured to control the varying of the position (X1,Y1) of the illuminated area (A1), wherein a maximum positional variation (ΔX1, ΔY1) of the illuminated area (A1) at the object plane (S1) is smaller than a minimum dimension (A1X,A1Y) across the illuminated area (A1).

## Description

### TECHNICAL FIELD AND BACKGROUND

The present disclosure relates to an optical system and a method for homogenizing an illuminated area.

Imaging systems such as used in lithography can be used to reproduce a pattern onto a substrate. For example, a mask pattern is placed in an object plane of the imaging system and the substrate is placed in the corresponding image plane. Typically, the mask comprises a transmissive and/or reflective pattern that is illuminated by a light beam. The light pattern resulting from the interaction of the light beam with the mask is transferred by the imaging system onto the substrate. However, when the illuminated area provided by the light beam is not homogeneous the resulting image quality may suffer. For example, variations of the illumination intensity profile may be transferred to the substrate image. Such inhomogeneities may be even more prominent when using a laser as light source for the illumination. In particular, the illuminated area of a laser beam typically comprise a plurality of bright spots, also known as speckle pattern, e.g. resulting from coherent interactions of the light.

To minimize or remove such bright spots, an optical diffuser can be placed in a path of the light beam. Typically, an optical diffuser causes scattering of the transmitted light, thereby distorting the wave front and/or evenly spreading the light over the illuminated area. The scattering can be caused e.g. by micro particles inside the diffuser and/or by surface roughening of its optical interface. However, known diffusers can have undesired side effects. For example, the diffusers may suffer from efficiency loss due to the scattering. For example, a diffuser may absorb a portion of the light which can result in heating and/or damage of the diffuser thus making the diffuser unsuitable for high energy light beams, especially for UV light. Furthermore, the scattering behaviour of the diffuser can be unpredictable, e.g. resulting in poor control over beam divergence. Furthermore, the disturbance of the wave front may result in an undesired increase of the étendue.

Accordingly, it is desired to provide a way for homogenizing an illumination area in an optical system while alleviating undesired effects of the known solutions.

### SUMMARY

A first aspect of the present disclosure provides an optical system. The optical system comprises an imaging system configured to image an object plane onto an imaging plane. The optical system comprises a light source configured to provide a light beam for illuminating an area at the object plane. The optical system comprises an optical diffuser configured to diffuse the light beam for homogenizing an intensity profile of the illuminated area. The optical diffuser comprises an optical element disposed in a light path between the light source and the object plane. The optical element is configured to redirect the light beam towards the object plane. The optical diffuser comprises an actuator configured to actuate the optical element for varying a position of the illuminated area at the object plane. The optical diffuser comprises a controller configured to control the varying of the position of the illuminated area, wherein a maximum positional variation of the illuminated area at the object plane is smaller than a minimum dimension across the illuminated area.

By actuating a redirecting element disposed in the beam, the position of the illuminated area can be varied in a controlled manner. By varying the position of the illuminated area, inhomogeneities can be spread out, e.g. time-averaged. By not relying on scattering, an efficiency and control of the light beam and illumination area can be improved. For example, by keeping the wave front intact, collimation and/or étendue of the light can be better preserved. Furthermore, by not absorbing the light, heating and/or damage can be avoided. Accordingly, the use of high energy light sources, in particular lasers, becomes available.

By keeping the positional variation relatively small compared to the cross section of the illuminated area, the edges of the moving illumination area can still fully encompass the pattern to be illuminated, while minimizing losses at the edges. For example, the maximum positional variation of the illuminated area at the object plane can be less than 10 percent of the minimum dimension across the illuminated area at the object plane, preferably, less than 1 percent, more preferably less than 0.1 percent, e.g. between 0.01 and 10 percent. Preferably, the positional variation is on the order of an average distance between the bright spots at the illumination area, e.g. the positional variation is between 0.1 and 10 times the average distance between bright spots. For example, a distance between bright spots is typically 10 - 100 micrometres while the illuminated area can be much larger, e.g. 50 by 30 millimetres. Accordingly, preferably a maximum positional variation of the illuminated area at the object plane is less than 1 millimetre, more preferably less than 500 micrometres, even more preferably less than 200 micrometres, e.g. between 5 and 100 micrometres.

Losses due to scattering and/or absorption can be minimized by using an optical element such as a mirror having a smooth optical interface. Advantageously, a mirror (e.g. dielectric) can be very efficient at reflecting the light. For example, the mirror can have a reflection efficiency (i.e. percentage of energy redirected towards the object plane) of more than 99%, more than 99.5%, or even more than 99.9%. Because the light does not have to travel through the mirror, absorption can be less. Alternatively, or in addition, the optical element comprises a transparent (non-diffusive) window. For example, the window can redirect the light beam by refraction at its optical interfaces. It will be appreciated that refraction can be more efficient than scattering, e.g. providing a transmission of more than 96 percent, more than 98 percent, or even more than 99 percent. For example, when a window is placed at the Brewster angle with respect to a polarized beam, reflection at its interfaces can be minimal. Alternatively, or in addition, by not scattering the light, the light beam can be redirected while preserving its étendue, e.g. less than 5 percent increase of the étendue by the optical element, preferably less than 1 percent, or even less than 0.5 percent, e.g. between 0.01 and 0.1 percent.

By providing a beam expander the illuminated area can be increased while still maintaining the smoothing effects of the actuated element. By disposing the expander between the optical element and the object plane, the beam can be relatively small when hitting the optical element. Accordingly, the optical element can be relatively small and demands on the actuator can be lowered.

By varying an angle of the optical element, an angle of the redirected beam can be varied. Alternatively, or in addition, the optical element can be rotated, e.g. wobbled, around it optical axis to redirect the beam. Alternatively, or in addition, the optical element can be moved along its optical axis to displace the beam.

By varying an angle of the optical element with respect to the light beam along two axes, the position of the illuminated area can be varied in two dimensions. Alternatively, or in addition, two or more actuated optical elements are configured to receive the light beam one after the other. For example, each of the elements can be actuated along one or more axes, to provide a combined effect on the movement of the light beam. By varying the position of the illuminated area in two dimensions, a better spreading of the inhomogeneities can be achieved. By providing separate actuation for different axes of the optical element, the two dimensional movement of the pattern can be controlled to extend a period of the movement. By extending a period of the movement, an even better spreading of the inhomogeneities can be achieved. For example, by choosing two actuation frequencies that are relative prime, e.g. not having a common denominator, a period of the movement can be maximized yet still controllable. When using a pulsed light beam, the controller can vary the position of the illuminated area as a function of the pulses of the light beam. By having relatively more pulses coincide in an area where the beam moves faster, a spread of the pulses over the illuminated area can be improved. In stead of a sinusoidal signal, the actuator can also be driven by other signals. For example, by using a saw tooth signal, a spreading of the light can be more homogeneous than a sinusoidal signal that has a relatively large staying time at the edges of the movement (where the movement speed is lower).

Advantageously, the actuator can operate at high frequency, e.g. providing a periodic movement along an axis of more than 100 Hertz, preferably, more than one kilohertz (kHz), e.g. between one and ten kHz. In one embodiment, the period of movement (reciprocal of the frequency) is shorter than the lighting time of the mask pattern, i.e. the time needed to effectively transfer the mask pattern onto the substrate. In one embodiment, a piezoelectric actuator is used to improve control over the movement of the optical element. In one embodiment, closed loop control is used to improve the control of the movement, e.g. to synchronize with a laser pulse frequency. Alternatively open loop control can be used to operate at higher frequencies.

It will be appreciated that the high efficiency of the optical element may allow the use of relatively high power light beams, with less risk of heating and/or damage. For example, the light source can be configured to provide a total illumination power of more than 3 Watt, more than 5 Watt, more than 10 Watt or even more.

It will be appreciated that the positional variation of the illumination area over a mask pattern disposed in the object plane need not affect the resolution of the resulting image. Accordingly, the present system may find application also in high resolution imaging, e.g. a lithography apparatus. For example, a mask pattern can be arranged at the object plane and a substrate at the image plane. Advantageously, the present methods and systems allow the lithographic apparatus to operate using a high power laser as light source. In particular, the present methods can provide sufficient homogenization to remove laser speckle and/or diffraction pattern while at the same time avoiding damage by absorption of the high power laser beam.

A second aspect of the present disclosure provides a method for homogenizing an intensity profile of an area illuminated by a light beam. The method comprises disposing an optical element in a path of the light beam. The optical element redirects the light beam towards the illuminated area. The method further comprises actuating the optical element to vary a position of the illuminated area, wherein a maximum positional variation of the illuminated area is smaller than a minimum dimension across the illuminated area. The method can be applied e.g. in combination with one or more of the element discussed herein. For example, the method can be used to homogenize an illumination area of an imaging system. Also other applications can be envisaged.

### BRIEF DESCRIPTION OF DRAWINGS

These and other features, aspects, and advantages of the apparatus, systems and methods of the present disclosure will become better understood from the following description, appended claims, and accompanying drawing wherein:
FIG 1 schematically shows an optical system according to one embodiment;
FIG 2 schematically shows a method for homogenizing an intensity profile;
FIG 3A schematically shows an intensity profile with a speckle pattern;
FIG 3B schematically shows the effect of spreading the intensity profile by moving the illuminated area;
FIGs 4A-4C schematically show embodiments of actuated elements;
FIGs 5A-5C schematically show embodiments of multiple actuated elements is series;
FIG 6A-6C schematically show embodiments comprising transparent elements;
FIG 7A-7D schematically show embodiments of steering control signals.

### DESCRIPTION OF EMBODIMENTS

Unless otherwise defined, all terms (including technical and scientific terms) used herein have the same meaning as commonly understood by one of ordinary skill in the art to which this invention belongs as read in the context of the description and drawings. It will be further understood that terms, such as those defined in commonly used dictionaries, should be interpreted as having a meaning that is consistent with their meaning in the context of the relevant art and will not be interpreted in an idealized or overly formal sense unless expressly so defined herein. In some instances, detailed descriptions of well-known devices and methods may be omitted so as not to obscure the description of the present systems and methods. Terminology used for describing particular embodiments is not intended to be limiting of the invention. As used herein, the singular forms "a", "an" and "the" are intended to include the plural forms as well, unless the context clearly indicates otherwise. The term "and/or" includes any and all combinations of one or more of the associated listed items. It will be understood that the terms "comprises" and/or "comprising" specify the presence of stated features but do not preclude the presence or addition of one or more other features. It will be further understood that when a particular step of a method is referred to as subsequent to another step, it can directly follow said other step or one or more intermediate steps may be carried out before carrying out the particular step, unless specified otherwise. Likewise it will be understood that when a connection between structures or components is described, this connection may be established directly or through intermediate structures or components unless specified otherwise. All publications, patent applications, patents, and other references mentioned herein are incorporated by reference in their entirety. In case of conflict, the present specification, including definitions, will control.

In one aspect of the present disclosure, a moving (e.g. rotating) diffuser is used for spreading out or scattering light in a some manner to remove the speckles or diffraction effects in order to obtain a homogeneous illumination. In the classical method light is diffused after passing through or reflecting from the diffuser surface by distorting the light wave front. These kind of diffusers suffer some deficiencies; for instance transmitting diffusers absorb a portion of light that can result heating up the diffusing element. The reflecting diffusers diverge the light collimation. The present disclosure may compensate some of these deficiencies and make it more practical e.g. for high power (collimated) lasers. For example, a reflecting mirror is mounted on top of a piezoelectric actuator so the mirror can tilt in two directions (x and y). The piezoelectric actuator can vibrate up to a few kHz frequency ranges, depending on the available technology. Due to the piezoelectric actuator vibrations the mounted mirror deflects the incoming rays. The deflected rays create a blurring effect on the image screen which results into a soft image construction. Depending on the coating of the mirror, the reflection of rays at certain wavelength or range of wavelengths can reach to > 99.9% (depending on coating technology, e.g. a dielectric mirror). The present disclosure can thus provide an efficient reflecting optical diffuser. Other benefits may include the use of high power lasers (low absorption), conserving the wave front of outgoing rays (keeps the reflecting light collimated), and/or defining manual diffusing pattern on the image screen (e.g. Lissajous Curve).

The invention is described more fully hereinafter with reference to the accompanying drawings, in which embodiments of the invention are shown. This invention may, however, be embodied in many different forms and should not be construed as limited to the embodiments set forth herein. Rather, these embodiments are provided so that this disclosure will be thorough and complete, and will fully convey the scope of the invention to those skilled in the art. The description of the exemplary embodiments is intended to be read in connection with the accompanying drawings, which are to be considered part of the entire written description. In the drawings, the absolute and relative sizes of systems, components, layers, and regions may be exaggerated for clarity. Embodiments may be described with reference to schematic and/or cross-section illustrations of possibly idealized embodiments and intermediate structures of the invention. In the description and drawings, like numbers refer to like elements throughout. Relative terms as well as derivatives thereof should be construed to refer to the orientation as then described or as shown in the drawing under discussion. These relative terms are for convenience of description and do not require that the system be constructed or operated in a particular orientation unless stated otherwise.

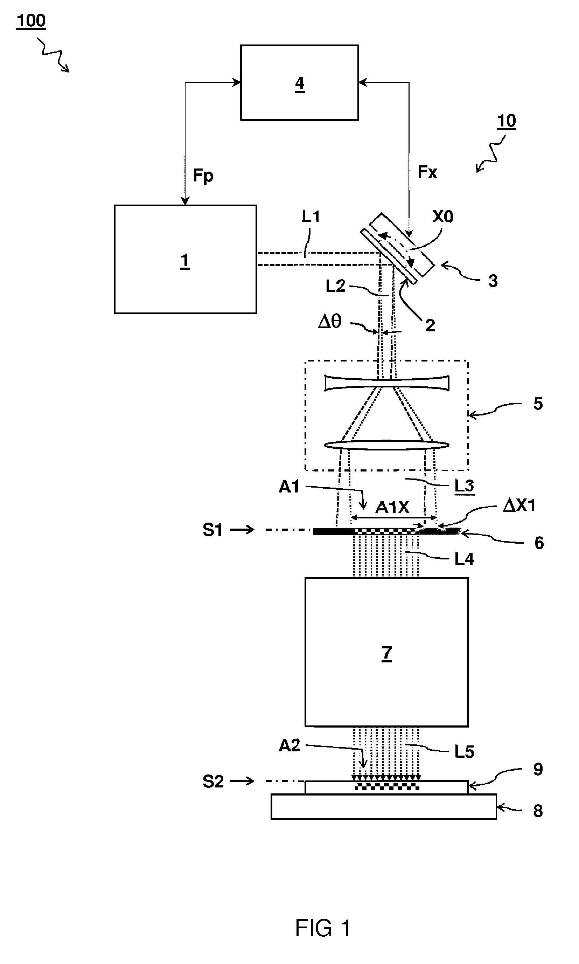

FIG 1 schematically shows an optical system 100 according to one embodiment.

In one embodiment, the optical system 100 comprises or couples to an imaging system 7 configured to image an object plane S1 onto an imaging plane S2. While the present disclosure provides particular benefit in combination with an imaging system, also other applications of the homogenized illumination can be envisaged.

In one embodiment, the optical system 100 comprises a light source 1 configured to provide a light beam L1 for illuminating an area A1, e.g. at the object plane S1. In one embodiment, the light source 1 comprises a laser. In one embodiment, the light source 1 is configured to provide a total illumination power at the object plane S1 of more than 3 Watt, more than 5 Watt, or even more than 10 Watt. The light source 1 can also be separate from the optical system 100. Alternatively, or in addition, the light source may comprise an aperture configured to provide a light beam to the system.

In one embodiment, the optical system 100 comprises an optical diffuser 10 configured to diffuse the light beam L1 for homogenizing an intensity profile of the illuminated area A1. It is noted that the term optical diffuser, is used herein to refer to the functionality of the said optical element, i.e. to diffuse the light over an illumination area. In contrast to traditional diffusers, the system does not need to rely on scattering to diffuse the light, e.g. preserving the wave front of the light beam.

In one embodiment, the optical system 100 comprises an optical element 2 disposed in a light path between the light source 1 and the object plane S1. In one embodiment, the optical element 2 is configured to redirect the light beam L1 towards the object plane S1. In one embodiment, the optical system 100 comprises an actuator 3 configured to actuate the optical element 2. In this way a position X1, Y1 of the illuminated area A1 at the object plane S1 can be varied. In one embodiment, the optical system 100 comprises a controller 4. The controller can be configured to control the varying of the position X1, Y1 of the illuminated area A1. The controller can be programmed to set a maximum positional variation ΔX1, ΔY1 of the illuminated area A1 at the object plane S1. In particular, the controller 4 can keep the maximum positional variation ΔX1, ΔY1 smaller than a minimum dimension A1X,A1Y across the illuminated area A1. The controller 4 can be separate or integrated in the actuator 3.

In one embodiment, the optical element 2 by itself (i.e. in static position) does not cause diffusion and/or divergence of the light beam L1. In one embodiment, the optical element 2 is configured to redirect the light beam L1 while preserving its étendue and/or collimation. Accordingly, in the said embodiment, the diffusing effect on the light beam is achieved exclusively or predominantly by the actuation of the optical element 2, e.g. by moving its optical interfaces with respect to the beam. Accordingly, the optical element 2 and the actuator 3 can work together to provide a functionality of an optical diffuser, e.g. homogenizing the light, without suffering disadvantages such as scattering loss

In one embodiment, an optical system 100, e.g. as described herein, is part of a lithography apparatus. In one embodiment, the optical system 100 comprises a mask stage 6. The mask stage 6 is arranged for positioning a mask 4, e.g. reticle, comprising a mask pattern at the object plane S1. Accordingly, the illuminated area A1 is patterned according to the mask pattern. In one embodiment, optical system 100 comprises a substrate stage 8 arranged for positioning a substrate 9. In one embodiment, the substrate 9 is configured to receive a substrate pattern onto the substrate 9 at the image plane S2 of the imaging system 7. In one embodiment, the projection system 7 is arranged for projecting an image of the mask pattern as the substrate pattern onto the substrate 9.

In one embodiment, the optical system 100 further comprises a beam expander 5. The beam expander 5 is configured to expand the redirected beam L2 to a wider beam L3 for increasing the illuminated area A1. In one embodiment, the beam expander 5 is disposed between the optical element 2 and the object plane S1.

In one embodiment, the beam L3 falls onto a mask pattern disposed at the object plane S1 of the imaging system 7. The patterned light beam L4 travels through the imaging system 7 and emerges as a projected beam L5 onto the substrate 9. Optionally, one or both of the mask stage 6 and/or substrate stage 8 can be moved before, during, and/or after the lighting process. In one embodiment, the controller 4 can send and/or receive steering signals Fp, Fx to the light source 1 and/or actuator 3, e.g. to control a power and/or pulse frequency of the light source 1 and/or a position and/or angle of the optical element 2. The controller can also be integrated into one or more of the components. Alternative, or in addition to the shown elements, the optical system may comprise further elements e.g. for the operation of a lithographic apparatus.

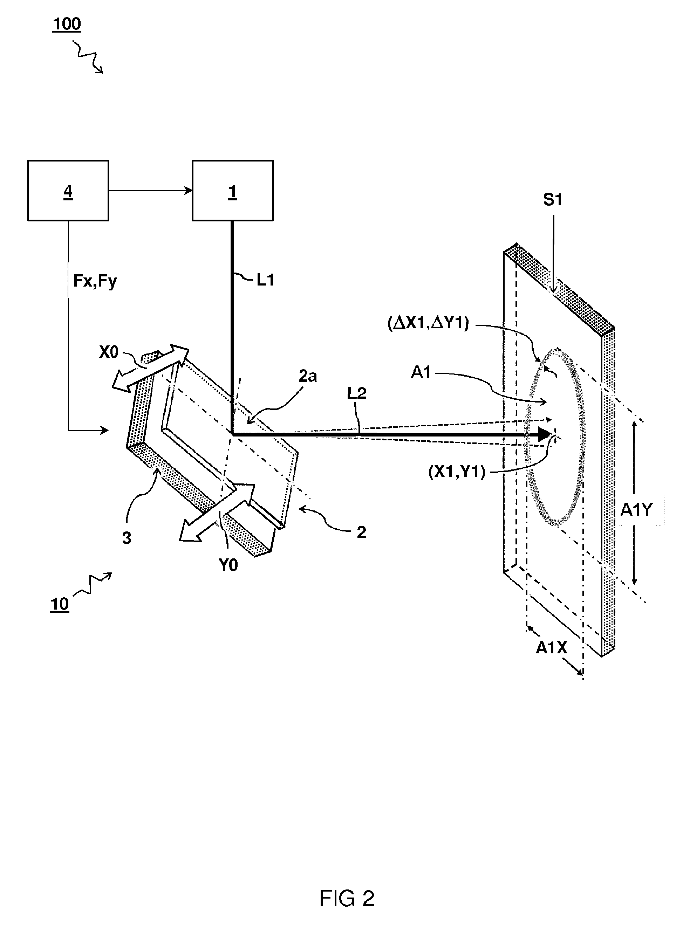

FIG 2 schematically shows a method for homogenizing an intensity profile of an area A1 illuminated by a light beam L1.

In one embodiment, the method comprises disposing an optical element 2 in a path of the light beam L1. The optical element 2 receives the light beam L1 from light source 1 onto its reflective surface 2a and redirects the light as beam L2 towards the illuminated area A1 at a target surface S1.

In one embodiment, the method comprises actuating the optical element 2 to vary a position X1, Y1 of the illuminated area A1. In one embodiment, the optical element 2 is actuated by an actuator 3. In one embodiment, a maximum positional variation ΔX1, ΔY1 of the illuminated area A1 is smaller than a minimum dimension within A1X,A1Y across the illuminated area A1.

In one embodiment, the actuator 3 is controlled by a controller via one or more steering signals Fx, Fy. In one embodiment, the controller 4 is configured to control the actuator 3 to vary an angle of the optical element 2 with respect to the light beam L1 along two axes X0, Y0 to provide a two dimensional positional variation ΔX1, ΔY1 of the illuminated area A1.

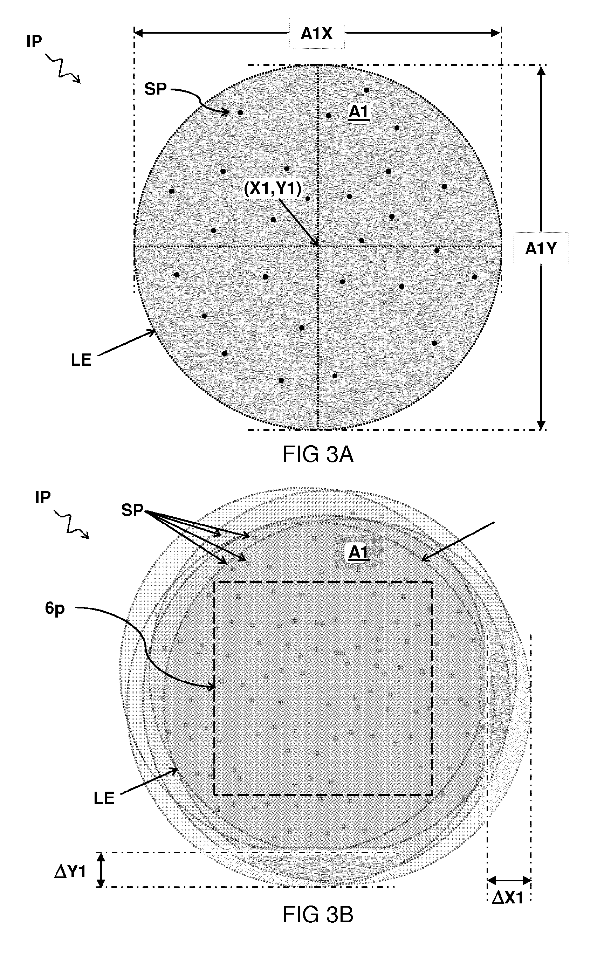

FIG 3A schematically shows an intensity profile IP of an illuminated area A1. The intensity profile IP comprises a speckle pattern SP, indicated schematically by a plurality of black dots. The illuminated area A1 is centred at position X1, Y1 and has dimensions A1X and A1Y. While the present illuminated area A1 is circularly shaped, also other area shapes are possible.

FIG 3B schematically shows the effect of spreading the intensity profile by moving the illuminated area A1. The effect is schematically shown by a series of overlapping reproduction of FIG 3A, wherein darker areas correspond to higher integrated light intensity. It may be noted that compared to FIG 3A, the speckle pattern has been spread around leading to an overall more homogeneous intensity profile IP, e.g. having a lower contrast ratio.

In one embodiment, the maximum positional variation ΔX1, ΔY1 is smaller than the minimum dimensions A1X,A1Y of the illuminated area A1. In one embodiment, the variation ΔX1, ΔY1 is between 0.01 and 10 percent of the minimum dimension A1X,A1Y across the illuminated area A1. In one embodiment, the variation ΔX1, ΔY1 is less than 1 millimetre, less than 500 micrometre, or even less than 100 micrometre. In one embodiment, the variation ΔX1, ΔY1 is such that a mask pattern 6p to be illuminated stay fully within the light edge perimeter LE of each of the superimposing illuminated areas A1. In this way, the intensity profile IP can be more homogeneous across the mask pattern 6p

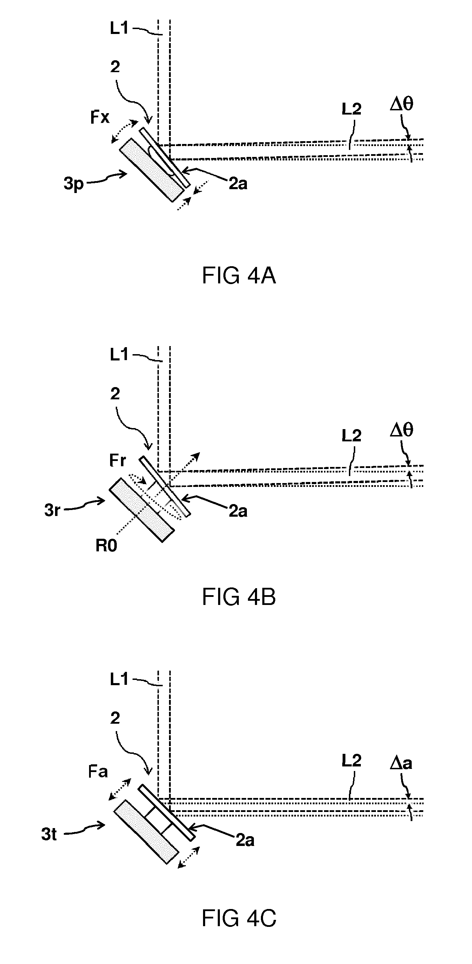

FIGs 4A-4C schematically show embodiments of optical elements 2 actuated by respective actuators 3p, 3r, 3t. In the shown embodiments, the optical element 2 comprises a mirror, wherein the mirror is configured to receive the light beam L1 and redirect it as light beam L2 by reflection off the mirror interface 2a. In one embodiment, the mirror is configured to reflect more than 99 percent of the beam L1, preferably more than 99.5 percent, or even more than 99.9 percent. In one embodiment, the optical element 2 is configured to forward at least 99 percent of the energy of the light beam L1, preferably more than 99.5 percent, or even more than 99.9 percent

FIG 4A shows a first embodiment, wherein the actuator 3p is configured to pivot the optical element 2, e.g. by a steering signal Fx. The pivoting of the mirror interface 2a causes an angular variation of the redirected beam L2. In one embodiment, the actuator 3 comprises a piezoelectric actuator to move the optical element 2. In one embodiment, a maximum angle Δθ over which the redirected beam L2 is moved is less than 100 microradians, less than 50 microradians, or even less than 20 microradians. It will be appreciated that e.g. a piezoelectric actuator can provide good control over small movement of the optical element 2. In one embodiment, the actuator 3p comprises two or more actuating element (not shown here) configured to pivot the mirror surface around two (independent) axes X0, Y0. See also for example FIG 2.

FIG 4B shows a second embodiment wherein the actuator comprises a rotator 3r configured to rotate or wobble the optical element 2 around a rotational axis R0. The rotational axis R0 is more or less transverse to optical surface 2a of the optical element 2. By wobbling the mirror surface 2a, the beam L2 can be periodically redirected in a circular motion over maximum angle Δθ.

FIG 4C shows a second embodiment wherein the actuator comprises a translator 3t configured to translate the optical element 2. For example, the translating actuator can vibrate the optical element 2 in a direction transverse to its optical interface 2a. It may be noted that the movement of the mirror 2 causes a lateral movement of the beam L2. In some applications, it can be advantageous to maintain the angle of the redirected beam L2. It will be appreciated that the collimation of the beam can also be preserved. In one embodiment, the actuator 3 and optical element 2 are configured to displace the beam over a distance Δa that is smaller than 1 millimetre, preferably less than 0.1 millimetre., e.g. between 10 and 100 micrometres.

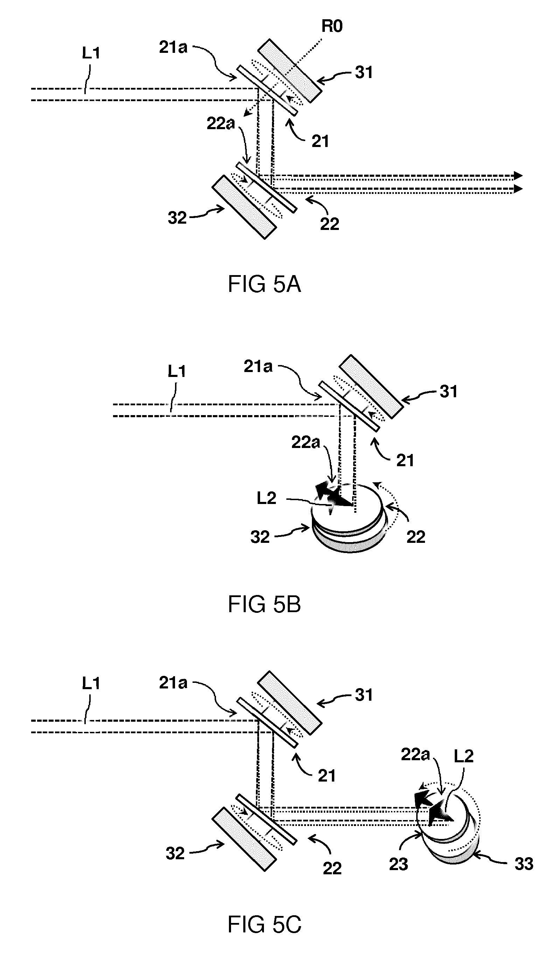

FIGs 5A-5C schematically show embodiments of multiple actuated elements 21,22 in series. In the embodiments shown, the optical system comprises a sequence of two or more actuated optical elements 21,22,23 configured to receive the light beam L1 one after the other. Each optical element 21,22,23 has a respective optical interface 21a, 22a, 23a and is actuated by a respective actuator 31,32,33. The combined effect of the actuated elements results in a redirected light beam L2. In the present embodiments, each of the actuator comprises a rotator. Other actuators, e.g. as shown in FIGs 4A-4C can be used in stead or in addition for achieving similar or further effect.

FIG 5A shows an embodiment, wherein a first actuator 31 and second actuator 32 operate their respective optical elements in counter phase. In particular, the mirror surfaces 21a and 22a are kept parallel during the actuating cycle. Advantageously, in this way the redirected beam can be displaced without affecting its angle. A similar effect can also be achieved by a pair of pivoting actuator 3v (not shown here).

FIG 5B shows another embodiment, wherein a pair of rotating actuators work together to provide a combined motion of the redirected beam L2. Advantageously, also non circular motion of the beam L2 can be achieved by two or more rotating actuators. It is noted that the rotating actuators can also be replaced by a respective pivoting actuators. For example, a pair of one dimensionally pivoting actuators can provide a combined two dimensional motion. Also a pair of translating or vibrating actuators can be used, e.g. laterally displacing the beam in two dimensions.

FIG 5C wherein a three rotating actuators and mirrors work together to provide a combined motion of the redirected beam L2. For example, the first pair of mirrors 21 and 22 can be configured similar to FIG 5A, i.e. displace the beam laterally without changing the angle. The third mirror can provide motion of the beam L2 along a further axis.

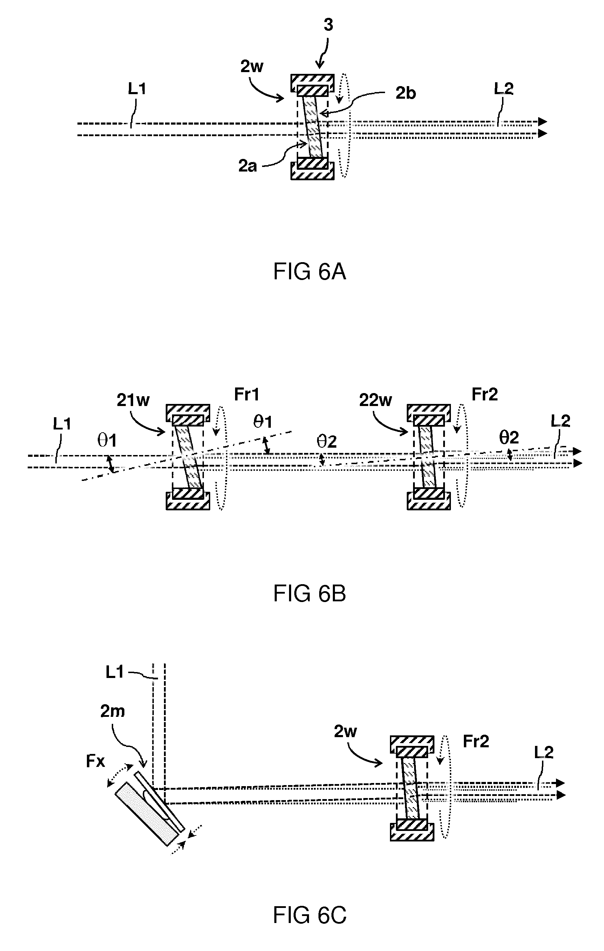

FIG 6A-6C schematically show embodiments comprising one or more transparent elements 2w. In one embodiment, the optical element comprises a non-diffusive transparent window 2w, wherein the window 2w is configured to redirect the light beam L1 by refraction at its optical interfaces 2a,2b. In one embodiment, the optical element is configured to transmit more than 98 percent of the light beam L1 to the plane to be illuminated, preferably more than 99 percent or even more than 99.5 percent. The term window may encompass also other transparent structures having smooth optical interfaces, e.g. wedge shaped.

FIG 6A shows a single window 2w rotated by an actuator 3 to wobble the optical interfaces 2a and 2b with respect to the light beam L1. The resulting beam L2 is laterally displaced in a periodic circular motion.

FIG 6B shows a pair of rotating windows 21w,22w placed in series. In one embodiment, a first window 21w is placed at a different angle with respect to the light beam L1 than the second window. In the shown embodiment, the first angle θ1 is larger than the second angle θ2. In this way the combined effect of the two windows can produce a non circular motion, in particular when the rotation frequencies Fr1 and Fr2 are also different.

FIG 6C shows an optical element comprising combination of a mirror 2m and a window 2w. Advantageously, a combination of elements can be used to further spread the motion of the beam.

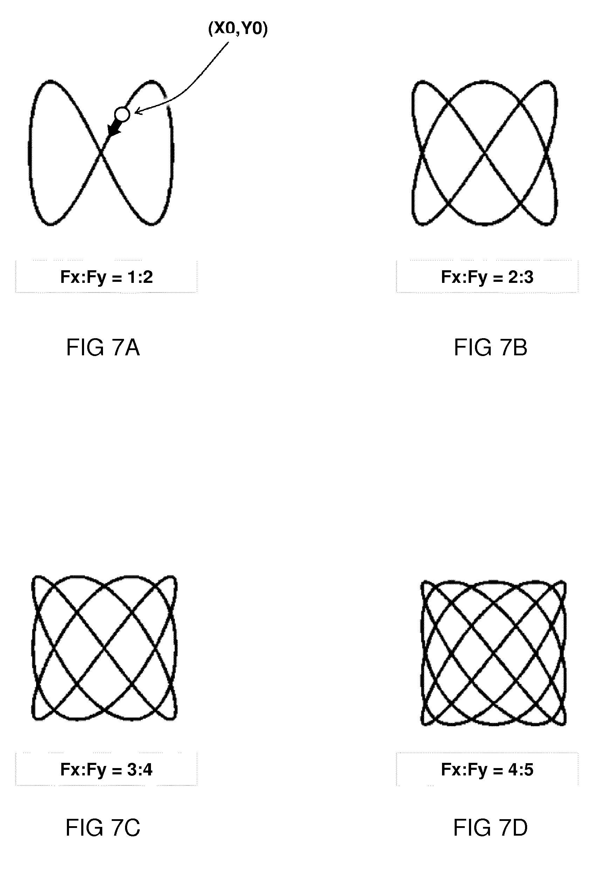

FIG 7A-7D schematically show embodiments of steering control signals. In one embodiment, the controller 4 is configured to control the actuator 3 to provide periodic actuation at two different actuation frequencies Fx, Fy. For example the optical element is actuated along a first axis X0 with a first of the two actuation frequencies Fx and actuated along a second axis Y0, transverse to the first axis X0, with a second of the two actuation frequencies Fy. In each of the figure 7A-7D, examples relative frequencies Fx and Fy are shown, with their resulting motion. In one embodiment, the two actuation frequencies Fx, Fy are relative prime. This can provide a longer period for the motion of the beam before it reconnects with itself. In stead of two steering signals, also a single steering signal can be used. Also more than two steering signals are possible. Multiple steering signals can be used to control a single actuator. Alternatively, or in addition, Multiple actuators can be controlled by a shared steering signal.

In one embodiment, the light source is configured to provide a pulsed light beam, wherein the controller is configured to vary the position of the illuminated area as a function of the pulses of the light beam, or vice versa, for maximizing a spread of illuminated areas associated with subsequent pulses for homogenizing the intensity profile of the illuminated area. In the present figures, the driving signals are sinusoidal. Also other periodic signals can be used, e.g. in one embodiment, the controller is arranged to drive the actuator by a periodic signal, wherein the periodic signal is a saw tooth signal. Also non periodic e.g. (semi) random signals can be used. In one embodiment, the controller is configured to control the actuator by closed loop control. In another or further embodiment, open loop control is used.

For the purpose of clarity and a concise description, features are described herein as part of the same or separate embodiments, however, it will be appreciated that the scope of the invention may include embodiments having combinations of all or some of the features described. For example, while embodiments were shown for an optical system comprising an transmissive imaging system, also alternative optical systems may be envisaged by those skilled in the art having the benefit of the present disclosure for achieving a similar function and result. E.g. optical, mechanical, and/or electrical components may be combined or split up into one or more alternative components. The various elements of the embodiments as discussed and shown offer certain advantages, such as homogenizing an illuminated area. Of course, it is to be appreciated that any one of the above embodiments or processes may be combined with one or more other embodiments or processes to provide even further improvements in finding and matching designs and advantages. It is appreciated that this disclosure offers particular advantages to imaging systems, and in general can be applied for any application wherein a homogeneous illumination of a target surface is desired.

While the present systems and methods have been described in particular detail with reference to specific exemplary embodiments thereof, it should also be appreciated that numerous modifications and alternative embodiments may be devised by those having ordinary skill in the art without departing from the scope of the present disclosure. For example, embodiments wherein devices or systems are disclosed to be arranged and/or constructed for performing a specified method or function inherently disclose the method or function as such and/or in combination with other disclosed embodiments of methods or systems. Furthermore, embodiments of methods are considered to inherently disclose their implementation in respective hardware, where possible, in combination with other disclosed embodiments of methods or systems. Furthermore, methods that can be embodied as program instructions, e.g. on a non-transient computer-readable storage medium, are considered inherently disclosed as such embodiment.

Finally, the above-discussion is intended to be merely illustrative of the present systems and/or methods and should not be construed as limiting the appended claims to any particular embodiment or group of embodiments. The specification and drawings are accordingly to be regarded in an illustrative manner and are not intended to limit the scope of the appended claims. In interpreting the appended claims, it should be understood that the word "comprising" does not exclude the presence of other elements or acts than those listed in a given claim; the word "a" or "an" preceding an element does not exclude the presence of a plurality of such elements; any reference signs in the claims do not limit their scope; several "means" may be represented by the same or different item(s) or implemented structure or function; any of the disclosed devices or portions thereof may be combined together or separated into further portions unless specifically stated otherwise. The mere fact that certain measures are recited in mutually different claims does not indicate that a combination of these measures cannot be used to advantage. In particular, all working combinations of the claims are considered inherently disclosed.

## Claims

1. An optical system (100) comprising
- an imaging system (7) configured to image an object plane (S1) onto an imaging plane (S2);
- a light source (1) configured to provide a light beam (L1) for illuminating an area (A1) at the object plane (S1);
- an optical diffuser (10) configured to diffuse the light beam (L1) for homogenizing an intensity profile of the illuminated area (A1); wherein the optical diffuser (10) comprises
o an optical element (2) disposed in a light path between the light source (1) and the object plane (S1), wherein the optical element (2) is configured to redirect the light beam (L1) towards the object plane (S1);
o an actuator (3) configured to actuate the optical element (2) for varying a position (X1, Y1) of the illuminated area (A1) at the object plane (S1); and
o a controller (4) configured to control the varying of the position (X1, Y1) of the illuminated area (A1), wherein a maximum positional variation (ΔX1, ΔY1) of the illuminated area (A1) at the object plane (S1) is smaller than a minimum dimension (A1X, A1Y) across the illuminated area (A1).

2. The optical system (100) according to claim 1, wherein the maximum positional variation (ΔX1, ΔY1) of the illuminated area (A1) at the object plane (S1) is between 0.01 and 10 percent of the minimum dimension (A1X,A1Y) across the illuminated area (A1) at the object plane (S1).

3. The optical system (100) according to any of the previous claims, wherein the optical element (2) comprises a mirror, wherein the mirror is configured to redirect the light beam (L1) by reflection off the mirror interface (2a).

4. The optical system (100) according to any of the previous claims, wherein the light source (1) comprises a laser.

5. The optical system (100) according to any of the previous claims, further comprising a beam expander (5) disposed between the optical element (2) and the object plane (S1), wherein the beam expander (5) is configured to expand the redirected beam (L2) for increasing the illuminated area (A1).

6. The optical system (100) according to any of the previous claims, wherein the controller (4) is configured to control the actuator (3) to vary an angle of the optical element (2) with respect to the light beam (L1) along two axes (X0, Y0) to provide a two dimensional positional variation (ΔX1, ΔY1) of the illuminated area (A1).

7. The optical system (100) according to any of the previous claims, wherein the controller (4) is configured to control the actuator (3) to provide periodic actuation at two different actuation frequencies (Fx,Fy), wherein the optical element is actuated along a first axis (X0) with a first of the two actuation frequencies (Fx) and actuated along a second axis (Y0), transverse to the first axis (X0), with a second of the two actuation frequencies (Fy).

8. The optical system (100) according to any of the previous claims, wherein the controller (4) is arranged to drive the actuator (3) by a periodic signal (Fx,Fy), wherein the periodic signal (Fx,Fy) is a saw tooth signal.

9. The optical system (100) according to any of the previous claims, wherein a maximum positional variation (ΔX1, ΔY1) of the illuminated area (A1) at the object plane (S1) is less than 1 millimetre.

10. The optical system (100) according to any of the previous claims wherein the optical element (2) is configured to redirect the light beam (L1) while preserving an étendue of the light beam (L1).

11. The optical system (100) according to any of the previous claims wherein the optical element (2) is configured to redirect at least 99% of the energy of the light beam (L1) towards the object plane (S1).

12. The optical system (100) according to any of the previous claims wherein the actuator (3) comprises a piezoelectric actuator.

13. The optical system (100) according to any of the previous claims, wherein the light source (1) is configured to provide a total illumination power at the object plane (S1) of more than 3 Watt.

14. Lithography apparatus comprising the optical system (100) according to any of the previous claims, the apparatus comprising a
- a mask stage (6) arranged for positioning a mask (4) comprising a mask pattern at the object plane (S1) of the imaging system (7) for patterning the illuminated area (A1) according to the mask pattern;
- a substrate stage (8) arranged for positioning a substrate (9) for receiving a substrate pattern (W) onto the substrate (9) at the image plane (S2) of the imaging system (7);
- wherein the imaging system (7) is arranged for projecting an image of the mask pattern as the substrate pattern onto the substrate (9).

15. Method for homogenizing an intensity profile of an area (A1) illuminated by a light beam (L1), the method comprising
- disposing an optical element (2) in a path of the light beam (L1), wherein the optical element (2) redirects the light beam (L1) towards the illuminated area (A1); and
- actuating the optical element (2) to vary a position (X1, Y1) of the illuminated area (A1), wherein a maximum positional variation (ΔX1, ΔY1) of the illuminated area (A1) is smaller than a minimum dimension (A1X,A1Y) across the illuminated area (A1).
